# EUROPÄISCHE PATENTANMELDUNG

(11) **EP 4 257 724 A1**
(43) Veröffentlichungstag der Anmeldung: **11.10.2023**
(21) Anmeldenummer: 23166561.3
(22) Anmeldetag: 04.04.2023
(51) Int. Cl.: C23C 16/30, C23C 16/40, C23C 16/44, C23C 16/448, C23C 16/452, C23C 16/455, C23C 16/48, C23C 16/54

(54) **VERFAHREN UND REAKTORKONFIGURATION ZUR HERSTELLUNG VON OXID- ODER OXINITRIDSCHICHTEN**

(30) Priorität: 05.04.2022 DE 102022108150
(71) Anmelder: ISSA, Esmail, 98693 Ilmenau (DE); Rädlein, Edda, 98701 Großbreitenbach (DE)
(72) Erfinder: ISSA, Esmail, 98693 Ilmenau (DE); Rädlein, Edda, 98701 Großbreitenbach (DE)
(74) Vertreter: Meyer, Rudolf

(57) **Zusammenfassung**

Mit der vorliegenden Erfindung wird ein neuartiges Abscheideverfahren und ein Reaktor für die Herstellung stöchiometrisch dünner Oxid- oder Oxinitridschichten bei Umgebungsdruck vorgeschlagen.

Diese Schichten werden durch Hydrolyse anorganischer Verbindungen wie der halogenhaltigen Gruppe der Metall-/ Nichtmetallhalogenide bei Umgebungsdruck abgeschieden. Das Hydrolysemittel wird im Wesentlichen vor und während der Vermischung mit dem anderen Reaktionsvorprodukt in seine Radikale zerlegt. Dies wird durch chemische Katalyse oder Photodissoziation ermöglicht. Die Abscheidung erfolgt bei Umgebungsdruck in einem Temperaturbereich von -20 bis 60 °C, vorzugsweise bei Raumtemperatur, wobei ein definierter Temperaturgradient zwischen der Substratoberfläche und der Gasmischzone der Abscheidevorrichtung eingestellt wird.

## Beschreibung

Die vorliegende Erfindung beschreibt ein neues Verfahren und eine Reaktorkonfiguration zur Herstellung von Oxid- oder Oxinitridschichten auf einem Substrat durch Hydrolyse von Verbindungen auf Halogenbasis, nämlich den anorganischen Halogeniden der Gruppe 17 des Periodensystems, bei Umgebungsdruck.

Die Halogenidverbindungen werden aus den Gruppen der Alkalimetalle, Übergangsmetalle, Halbmetalle und Nichtmetalle ausgewählt. Als Beispiele, aber nicht ausschließlich, seien Na, Ti, Zr, Hf, V, Cr, W, Zn, B, Al, Ga, Si, Ge, Sn, P usw. genannt. Bei den halogenhaltigen Halogeniden handelt es sich vorzugsweise um Chlor-, Brom- oder Jodverbindungen, die entweder aus der flüssigen Phase verdampft oder aus der festen/verflüssigten Phase durch Einwirkung einer verträglichen Säure zu Dampf reduziert werden. Als Hydrolysereagenzien werden H₂O oder H₂O₂ verwendet, die aus der flüssigen Phase verdampft werden, z. B. mit einem isolierten Bubbler. Für den Fall, dass die Abscheidung von Oxynitridschichten beabsichtigt und eine chemische Katalyse zur Stimulierung der Reaktion erforderlich ist, wird NH₃-Dampf verwendet.

Aus dem Stand der Technik sind Verfahren für die chemische Abscheidung von dünnen Oxidschichten aus der Gasphase bei Umgebungsdruck bekannt, bei denen verschiedene Arten von organischen oder anorganischen Vorläufermaterialien verwendet werden.

Bei der chemischen Gasphasenabscheidung (CVD) unter Umgebungsdruck handelt es sich um eine molekulare diffusionsgesteuerte Reaktion, die auch als homogene Gasphasenreaktion (HMG) bezeichnet wird. Diese Reaktion erfolgt in folgenden fünf Schritten: i) Transport der Gasvorläufer in die Reaktionszone, ii) Bildung eines homogenen HMG-Zwischenprodukts (IMP) vor dem Substrat, iii) Diffusion des IMP und anschließende Adsorption auf der Substratoberfläche, iv) heterogene Reaktion (HTG) des IMP mit der Substratoberfläche, v) Schichtbildung und Desorption der Reaktionsnebenprodukte von der Substratoberfläche.

Nach diesen Schritten werden die Nebenprodukte gezielt mit Hilfe der Abluft entfernt. Der Hauptnachteil dieses Abscheidungsverfahrens ist die Bildung des HMG-Zwischenprodukts (IMP) vor dem Substrat, welches sowohl zu einer parasitären Partikelproduktion als auch zu einer geringeren Qualität der abgeschiedenen Schicht aufgrund sich bildender Hohlräume und Verunreinigungen im Schichtinneren führt.

Im Gegensatz zu diesen bekannten Verfahren zeichnet sich die Atomlagenabscheidung (ALD) durch eine heterogene, oberflächengesteuerte Reaktion aus, da es keine kontinuierliche Wechselwirkung zwischen den chemischen Reaktanten im Gasvolumen gibt. Diese ist lediglich auf die Substratoberfläche beschränkt. Dieses Abscheideverfahren umfasst die folgenden vier Schritte: i) Transport der Reaktanten, ii) Diffusion der Reaktanten und anschließende Adsorption auf der Substratoberfläche, iii) heterogene Reaktion (HTG) zwischen den Reaktanten und der Substratoberfläche, iv) Schichtabscheidung und Desorption der Reaktionsnebenprodukte von der Substratoberfläche. Dies führt zu einer hohen Qualität der abgeschiedenen Schichten, da keine Hohlräume und anhaftenden Agglomerate vorhanden sind.

Andere Abscheidungsverfahren, wie die Niederdruck- und plasmaunterstützte chemische Gasphasenabscheidung (LPCVD bzw. PECVD), sind aufgrund des erforderlichen Vakuums und der damit verbundenen großen mittleren freien Weglänge durch eine heterogene Reaktion und eine vernachlässigbare homogene Gasphasenreaktion charakterisiert. Es ist bekannt, dass die homogene Reaktion umso stärker ausfällt, je höher die Abscheidungstemperatur (eine Voraussetzung für die energetische Aktivierung der Abscheidung) und / oder je höher der Partialdruck der Reaktanten-Lösungen ist (s. h. Vladislav Yu. Vassiliev, Relationships Between Gas-Phase Film Deposition, Properties and Structures of Thin SiO2 and BPSG Films, J. Electrochem. Soc. 150 (2003) F211-F218. https://doi.org/10.1149/1.1623770). Je länger die Verweilzeit der Reaktanten im Reaktionsvolumen ist, desto größer ist die Wahrscheinlichkeit, dass eine homogene Reaktion stattfindet, und desto rauer und minderwertiger sind die abgeschiedenen Schichten. Dies ist darauf zurückzuführen, dass die vor der Substratoberfläche gebildeten IMP-Cluster den Hauptanteil der entstehenden Schicht ausmachen.

Darüber hinaus ist die Reaktionszeit ein weiterer zu berücksichtigender Aspekt, mit dem die chemische Stöchiometrie, die Materialreinheit und die Gleichmäßigkeit der Verbindungen in der abgeschiedenen Schicht sichergestellt werden kann. Je länger die mittlere freie Weglänge der reaktiven Ionen ist, desto stöchiometrischer ist das entstehende Produkt und desto gleichmäßiger sind Zusammensetzung und Schichtdicke. Dies ist darauf zurückzuführen, dass aufgrund des in der Reaktionskammer herrschenden niedrigen Drucks bei PECVD, LPCVD und ALD genügend Platz zwischen den kollidierenden Ionen / Molekülen zur Verfügung steht. Dadurch können sich die Ionen / Moleküle über weite Strecken fortbewegen, was zu einer stärkeren Wechselwirkung innerhalb des Gases führt. Andererseits gilt: Je höher die Aktivierungsenergie der Reaktion ist, desto größer ist die Mobilität der kollidierenden Ionen / Moleküle bei niedrigem Druck und desto höher ist die Kollisionshäufigkeit, d. h. desto stärker dissoziieren die Reaktanten, was zu einer höheren Reaktionsgeschwindigkeit führt. Folglich kommt es zu einer vollständigen Reaktion zwischen den Reaktanten und somit zu stöchiometrisch zusammengesetzten Produkten ohne Verunreinigungen.

Herkömmliche CVD-Anlagen arbeiten mit einer thermischen Aktivierungsenergie, die über hohe Gas-Temperaturen (von 400 bis 1700 ºC) bereitgestellt wird. Bei Abscheidungssystemen mit vergleichsweise niedrigen Temperaturen (25 - 150 Cº) wird die Dissoziation der Reaktanten entweder durch Plasmazufuhr, wie bei der PECVD und einigen Umgebungsdruck-CVDs, oder durch Reaktionskatalyse, wie bei der ALD, ausgelöst und unterstützt.

Die wesentlichen Hindernisse für eine gleichmäßige Abscheidung stöchiometrischer Oxid- / Oxynitrid-Schichten mittels CVD bei Umgebungsdruck sind, dass die mittlere freie Weglänge der Reaktanten-Moleküle viel kürzer als in den evakuierten Anlagen ist und dass die Energie der Reaktionseinleitung und -beendigung viel geringer als bei LPCVD, PECVD und ALD ist. Dies hat zur Folge, dass bei der Hydrolyse von anorganischen Halogenidverbindungen unter Umgebungsdruck das Aufbrechen der chemischen Bindungen und die Dissoziation der Reaktanten-Moleküle unzureichend und die entsprechende Reaktion daher unvollständig ist.

In den meisten CVD-Anlagen, die unter Umgebungsdruck arbeiten, wird das zu beschichtende Substrat mit einer hohen Temperatur beaufschlagt (ähnlich wie bei den Kaltwand-PECVD-Anlagen), während die Temperatur der Kammerwände weitaus geringer ist. Da jedoch zahlreiche chemische Reaktionen für ihre Aktivierung ein hohes Wärmebudget erfordern, z. B. die Reaktion von SiH₄ mit N₂O oder Ti(O-i-C₃H₇)₄ mit O₂, werden in der thermischen Grenzschicht auf der Substratoberfläche IMPs selektiv gebildet. Folglich ist die Einstellung eines definierten Temperaturprofils in der Reaktionskammer ein geeignetes Mittel zur Beherrschung der Gasphasenreaktion in CVD-Anlagen, die mit Umgebungsdruck betrieben werden.

Daneben sind aus dem Stand der Technik verschiedene Verfahren zur Einbringung der gasförmigen Reaktanten in die CVD-Anlagen bekannt. So wird z.B. in der US 6,743,516 beschrieben, dass sich Siliziumoxidfilme (poröse und raue SiO₄-Schichten) unter Umgebungsdruck mit SiCl₄ als Silizium-Quelle und H₂O-Dampf als Sauerstoff-Quelle und bei Raumtemperatur mit Hilfe von Pentan Dampf erzeugen lassen. Diese Schichten werden hauptsächlich auf Glassubstrate aufgebracht, um die anschließende Abscheidung von Antireflexions- und hydrophoben Schichten zu unterstützen. Bei diesem Ansatz werden die Reaktanten vor der Einleitung in die Reaktionskammer nicht vermischt, sondern derart sequentiell eingeleitet, dass das gesamte Kammervolumen mit H₂O-Dampf gefüllt und anschließend der SiCl₄-Dampf für kurze Zeit eingeleitet wird. Dies führt jedoch zu einer Verschwendung von Precursoren innerhalb des Kammervolumens und einer hohen Wahrscheinlichkeit der Bildung von Oxidstaub. Darüber hinaus führt eine Verringerung der SiCl₄-Konzentration zu Abscheidungsraten von nur wenigen nm/min. Außerdem wird die Luftfeuchtigkeit im Laufe der Zeit allmählich verbraucht, so dass sich die SiOₓ-Abscheidungsrate im Verlauf des Abscheidungsprozesses verringert.

Ein ähnlicher Ansatz zur Abscheidung von SiO₂-Filmen ist aus der US 11/878,023 bekannt, die als kolloidale Beschichtung für hoch geordnete Gitter aus monodispersen Mikropartikeln aus Siliziumdioxid dienen. Bei diesem Verfahren findet keine anfängliche Vermischung der Reaktanten statt, auch nicht auf der Probenoberfläche. Das liegt daran, dass die Einleitung der gasförmigen Reaktanten nicht gleichzeitig erfolgt. Stattdessen erfolgt eine alternierende Abscheidung von H₂O- und SiCl₄-Dampf, ähnlich der Prozessfolge bei der Atomlagenabscheidung (ALD). Dazwischen wird nach jedem Zyklus eine Spülung durchgeführt, um den überschüssigen Wasserdampf abzuspülen, so dass der unmittelbare Kontakt zwischen den Reaktanten vermieden wird. Die Abscheidungsrate der auf diese Weise hergestellten SiO₂-Schichten erweist sich jedoch als zu niedrig (≤ 2 nm/min). Daraus resultiert eine Schichtdicke von z.B. 250 nm nach 10-12 Zyklen, wobei jeder Zyklus 20 bis 40 Minuten dauert.

Aufgabe der vorliegenden Erfindung ist es, die Nachteile aus dem Stand der Technik zu überwinden, und ein Verfahren und eine Reaktorkonfiguration zur Herstellung von hochqualitativen und hochbelastbaren Oxid- oder Oxinitridschichten durch Hydrolyse von Verbindungen auf Halogenbasis bei Umgebungsdruck, mit denen eine hohe Abscheidungsrate mit geringem Investitionsaufwand und vernachlässigbarem Wärmehaushalt realisiert werden kann, wobei der dazugehörige Reaktor einfach aufgebaut und vakuum- und plasmafrei sowie langlebig und sicher betrieben werden kann.

Erfindungsgemäß gelingt dieser Aufgabe mit den Merkmalen des ersten und sechsten Patentanspruchs. Vorteilhafte Ausgestaltungen der erfindungsgemäßen Lösung sind in den Unteransprüchen angegeben.

Mit der vorliegenden Erfindung wird ein neuartiges Abscheideverfahren und ein Reaktor für die Herstellung stöchiometrisch dünner Oxid- oder Oxinitridschichten bei Umgebungsdruck vorgeschlagen, wobei die Schichtdicke zwischen 1 Nanometer bis zu einigen Mikrometern variieren kann. Diese Schichten werden durch Hydrolyse anorganischer Verbindungen wie der halogenhaltigen Gruppe der Metall-/ Nichtmetallhalogenide bei Umgebungsdruck abgeschieden. Das Hydrolysemittel wird im Wesentlichen vor und während der Vermischung mit dem anderen Reaktionsvorprodukt in seine Radikale zerlegt. Dies wird durch chemische Katalyse und / oder Photodissoziation ermöglicht. Die Abscheidung erfolgt bei Umgebungsdruck in einem Temperaturbereich von -20 bis 60 °C, vorzugsweise bei Raumtemperatur, wobei ein definierter Temperaturgradient zwischen der Substratoberfläche und der Gasmischzone der Abscheidevorrichtung eingestellt wird.

Die abgeschiedenen Schichten bestehen entweder aus isolierenden oder elektrisch leitenden Materialien, die glasartig und amorph sind. Die Eigenschaften der Schichten können je nach Verwendungszweck von extrem dicht bis extrem porös variieren. Die abgeschiedenen Schichten können als dielektrische Schicht, Passivierungsschicht für Halbleiterbauelemente, Dotierstoffquelle, transparentes leitfähiges Oxid (TCO), photoaktivierte Schicht, Schutzschicht gegen Ätzmittel, Schutzschicht gegen Dotierstoffe oder Diffusion, Schutzschicht gegen Verwitterung, Deckschicht für darunter liegende Objekte, Antireflexionsschicht, Reflektor oder Streuschicht, Filter mit definierter Wellenlänge, poröse Filmschicht für Metalllegierungen, poröser Film, der mit verschiedenen Oxiden gefüllt ist, Ankerschicht für übereinander liegende Schichten, hydrophobe oder Anti-Haze-Verkapselung, dauerhafte Schicht zur Härtung der Oberflächen von Schneidwerkzeugen, kolloidale oder schwebende Schicht, texturierte oder knotige Schicht, Galvanisierungsmaske für die Metallisierung von Halbleiterbauelementen und vieles mehr verwendet werden. Sie sind mit jeder Substratform oder -struktur kompatibel, unabhängig von der Oberflächenmorphologie. Beispiele hierfür sind ebene Oberflächen, strukturierte Oberflächen, stufenförmig strukturierte Oberflächen, konvexe und konkave Oberflächen, runde Objekte, kugelförmige Formen, knotige Strukturen, zylindrische oder röhrenförmige Objekte, gitterförmige Medien, poröse oder dicht strukturierte, unregelmäßige Mikro- oder Nanopartikel usw.

Mit dieser Erfindung wird vorgeschlagen, die Abscheidung von Oxid- oder Oxinitridschichten unter Umgebungsbedingungen mit einer oberflächengesteuerten anstelle einer molekularen diffusionsgesteuerten Reaktion zu realisieren. Dies wirkt sich vorteilhaft bei der Unterdrückung der Bildung von parasitären Oxidpartikeln aus und ermöglicht somit eine genaue Bestimmung der Reinheit, Struktur, Oberflächenrauheit, Abscheidungsrate sowie der physikalischen und chemischen Eigenschaften der abgeschiedenen Schicht.

Da eine von der Substratoberfläche weit entfernte Vermischung der Halogenid-H₂O-Moleküle zu Verunreinigungen führt (wegen der sofortigen Reaktion bei entsprechender Kollision), wird mit diesem neuartigen Verfahren vorgeschlagen, eine langsame Vermischung der Halogenid-H₂O-Moleküle bis zum Erreichen der Substratoberfläche zu bewirken, ohne dass sie miteinander reagieren. Ermöglicht wird dies durch eine Umkehrung der exothermen Reaktion der Halogenidhydrolyse, z.B. durch die Bereitstellung von Substitutionsenergie und -produkten. Dadurch verschiebt sich das Reaktionsgleichgewicht in Richtung der Reaktanten und nicht in Richtung der Produkte, so dass die IMPs kontinuierlich in der Gasphase gebildet und zersetzt werden, wodurch die Bildung unerwünschter Produkte (Oxidpartikel) verhindert wird. Darüber hinaus wird davon ausgegangen, dass die langsame Durchmischung und die lange Verweilzeit der Reaktanten in der Abscheidevorrichtung die kurze mittlere freie Weglänge der kollidierenden Moleküle kompensieren.

Das erfindungsgemäße Verfahren wird im Folgenden "Surface Reaction Controlled Ambient Chemical Vapor Deposition" (SRA-CVD) genannt. Der dazugehörige Reaktor zur Durchführung dieses Verfahrens wird nachfolgend als SRA-CVD-Reaktor bezeichnet.

Die stöchiometrische Zusammensetzung und die gleichmäßige Dicke der abgeschiedenen Schicht sind wesentliche Anforderungen an ein CVD-Verfahren. Es ist weitgehend bekannt, dass eine gleichmäßig stöchiometrische Vermischung der Reaktanten auf der Substratoberfläche erforderlich ist, um stöchiometrische und gleichmäßige Schichten zu erhalten. Diese Voraussetzung wird erfindungsgemäß mit zwei gleichzeitig wirkenden Maßnahmen gelöst: Zum einen wird ein homogenes und stöchiometrisches Reaktanten-Gemisch direkt vor der gewünschten Substratoberfläche bereitgestellt. Zum anderen wird die Bindungsdissoziation der Reaktanten-Moleküle in der Gasphasenmischung verstärkt, so dass unvollständige Reaktionen der IMPs, die unter Umgebungsbedingungen aufgrund der kurzen mittleren freien Weglänge bekanntlich auftreten, an der Substratoberfläche vermieden werden.

Der dazugehörige SRA-CVD-Reaktor ist aus Teflon, teflonbeschichteten Kunststoffen oder hydrophoben oxidbeschichteten Materialien aufgebaut und umfasst im wesentlichen Reaktanten-Verdampfer und eine Abscheidevorrichtung, die in einer spülbaren Dichtkammer angeordnet sind. Die oberflächengesteuerte Reaktion findet in der Abscheidevorrichtung statt, die während des Abscheideprozesses ausreichend abgedichtet ist.

Mit dem vorgeschlagenen Verfahren können Oxid- oder Oxinitridschichten wie SiOₓ, SiOₓN_{y}, GaOₓN_{y}, TiOₓ, TiOₓN_{y}, ZnOₓ, ZnOₓN_{y}, SnOₓ, AlOₓ, gemischtes SiOₓ.AlOₓ, gemischtes SiOₓ.TiOₓ, GeOₓ, ZrOₓ, HfOₓ, VOₓ, CrOₓ, WOₓ, P-dotiertes Oxid, N-dotiertes Oxid oder eine Kombination aus diesen Materialien hergestellt und für verschiedene Anwendungen eingesetzt werden. Die Schichten können beispielsweise als Schutz verschiedener Substrate vor alkalischen und sauren Lösungen, als Dotierstoffquelle, als elektrisch isolierende Schicht, als elektrisch leitende und transparente Schicht, als Passivierungs-/Isolierschicht, als hydrophobe Beschichtung, als Antireflexionsschicht, als Einwegreflektor usw. verwendet werden. Die Anwendungsbereiche könnten beispielsweise Photovoltaik (PV), optische Fasern, verschiedene Halbleiter, Glasindustrie, Mikrosystemtechnik / Mikroelektronik, Automobilindustrie usw. sein.

Es wird vorgeschlagen, dass die gewünschten Oxidschichten unter atmosphärischen Bedingungen und bei Temperaturen zwischen -20 und 60 °C, vorzugsweise bei 23 °C, abgeschieden werden. Dabei sind die wichtigsten benötigten chemischen Reaktanten anorganische und / oder in einigen Fällen organische Si-haltige Verbindungen, vorzugsweise metallische / halbmetallische / nichtmetallische Halogenide, besonders bevorzugt z. B. SiCl₄, SiBr₄, GaCl₃, GaBr3, TiCl₄, TiBr₄, ZnCl₂, ZnBr₂, SnCl₄, SnBr4, AlCl₃, AlBr₃, GeCl₄, GeBr₄, VCl₄, VBr₄, ZrCl₄, ZrBr₄, HfCl₄, HfBr₄, VCl₄, VBr₄, CrClₓ, CrBrₓ, WCl₆, WBr₆, usw.

Jodidhaltige Halogenide werden in dieser Erfindung ebenfalls bevorzugt, während Halogenide auf Fluoridbasis aufgrund der Entwicklung von Flusssäure und der damit verbundenen Risiken in dieser Erfindung nicht bevorzugt sind.

Die gewünschten Oxidschichten werden durch Hydrolyse der genannten Halogenide mit deionisiertem H₂O oder H₂O₂-Dämpfen in Gegenwart eines katalytischen Reagenzes wie Cl₂, HCl, NH₃ oder anderen gebildet. Cl₂-Gas wird verwendet, um die H₂O-Moleküle zu dissoziieren, wodurch im Gasmedium instabile OH⁻- und H₃O⁺-Radikale gebildet werden, die zur Substratoberfläche diffundieren. Infolgedessen wird das Halogenid zunächst hydrolysiert und anschließend die SiClₓOH_{y}-Zwischenprodukte gebildet.

Als zusätzliche oder alternative Maßnahme wird die Hydrolyse der Halogenide während der Schichtabscheidung kontinuierlich durch ultraviolette (UV) Strahlung unterstützt, die auf die hydrolysierten H₂O- oder H₂O₂-Dämpfe in der Gasmischeinheit der Abscheidevorrichtung sowie auf die Substratoberfläche trifft. Dabei wird die photokatalytische Wirkung der UV-Strahlung genutzt, um die Moleküle der hydrolysierten Dämpfe in ihrem jeweiligen Gasstrom und auf der Substratoberfläche zu dissoziieren, wodurch instabile OH⁻ -Radikale entstehen.

Die Gasmischeinheit in der Abscheidevorrichtung umfasst einen porösen Körper aus gesinterten TiOₓ/ZnO-Partikeln oder aus kolloidalem TiOₓ/ZnO, welches mit Glasgittern, gesinterten Glaspartikeln oder Glastextilien beschichtet ist und mit UV-Licht bestrahlt wird. Wenn die dampfförmigen Reaktanten durch den porösen Körper der Gasmischeinheit strömen, werden die Moleküle der hydrolysierten Dämpfe aufgrund des mittels UV-Strahlung photoaktivierten TiOₓ/ZnO dissoziiert. Dazu wird die UV-Wellenlänge vorteilhaft im Bereich zwischen 115 und 300 nm gewählt, der unter Atmosphärendruck wirksam ist. Die Erzeugung von OH⁻ -Radikalen ist eine wesentliche Voraussetzung für die vollständige Hydrolyse der Halogenide und damit für stöchiometrische Oxid- oder Oxinitridschichten, die frei von Hydroxyl-Verunreinigungen sind. Falls es für bestimmte kritische Anwendungen erforderlich ist, kann eine weitere insitu-Dehydratisierungsbehandlung einer ggf. schrittweise abgeschiedenen Schicht im Reaktor durchgeführt werden. Dies kann durch eine sequenzielle thermische Aushärtung der einzelnen Schichten bei Temperaturen von 150 bis 400 °C und einer Dauer von 5 s bis 5 min, je nach der beabsichtigten Anwendung, realisiert werden.

Um die Hydrolyse der Halogenid-Moleküle in der Gasphase zu unterdrücken, wird weiterhin vorgeschlagen, das Gasgemisch in der Abscheidevorrichtung mit Wärmeenergie zu beaufschlagen. Dazu wird das Gasgemisch in der Abscheidevorrichtung mit Infrarotlicht (IR) auf eine Temperatur zwischen 40 und 80 °C erwärmt, wobei der Bereich der Substratoberfläche von dieser IR-Bestrahlung ausgenommen bleibt. Dadurch wird die Verschiebung des Reaktionsgleichgewichts im Gasmedium von der Seite der Produkte zur Seite der Reaktanten sichergestellt, da die Hydrolyse der Halogenide in der Gasphase eine exotherme Reaktion ist.

Eine weitere Möglichkeit, die Reaktion der Halogenid-Moleküle in der Gasphase zu unterdrücken, besteht darin, vor und während des Abscheidungsprozesses eine bestimmte Menge HCl-Gas zuzuführen oder das bei der Katalyse mit Cl₂-Molekülen entstehende HCl zu verwenden. Die auf diese Weise durchgeführte Abscheidung führt zu einer beiderseitigen Reaktion, also zur Bildung und zum Zerfall von Zwischenprodukten oberhalb des Substrates. Da HCl schnell von der Substratoberfläche desorbiert wird, hydrolysieren die verbleibenden OH⁻ -Radikale die SiClₓOH_{y}-Zwischenprodukte (IMPs) weiter, im Gegensatz zu denen im Gasvolumen, wo HCl reichlich vorhanden ist. Dies wiederum führt dazu, dass die Oberflächenreaktion wesentlich schneller abgeschlossen wird und sich auf der Substratoberfläche eine OxidSchicht bildet. Infolgedessen wird die Bildung von Oxidpartikeln im gesamten Innenraum und an den Apparatewänden verhindert, was aufgrund der sofortigen Reaktion zwischen H₂O/H₂O₂ und den Halogeniden eine Herausforderung darstellt.

Der SRA-CVD-Reaktor besteht im Wesentlichen aus einer geschlossenen Abscheidevorrichtung, die in einer gereinigten Dichtkammer angeordnet ist, sowie aus Halogenid-, Katalysator- und Hydrolysedampfzuführungssystemen. Die Materialien, aus denen der Reaktor besteht, sind nicht korrosiv und wasserabweisend; vorzugsweise werden Teflon, teflonbeschichtete Materialien, Materialien mit fluorierter Oberfläche, Kunststoffe, mit glasartigem Oxid beschichtete Materialien, mit photokatalytischen Halbleitern beschichtete Materialien usw. verwendet. Für die Abdichtung der abwechselnd geöffneten und geschlossenen Volumina werden Silikonmaterialien verwendet.

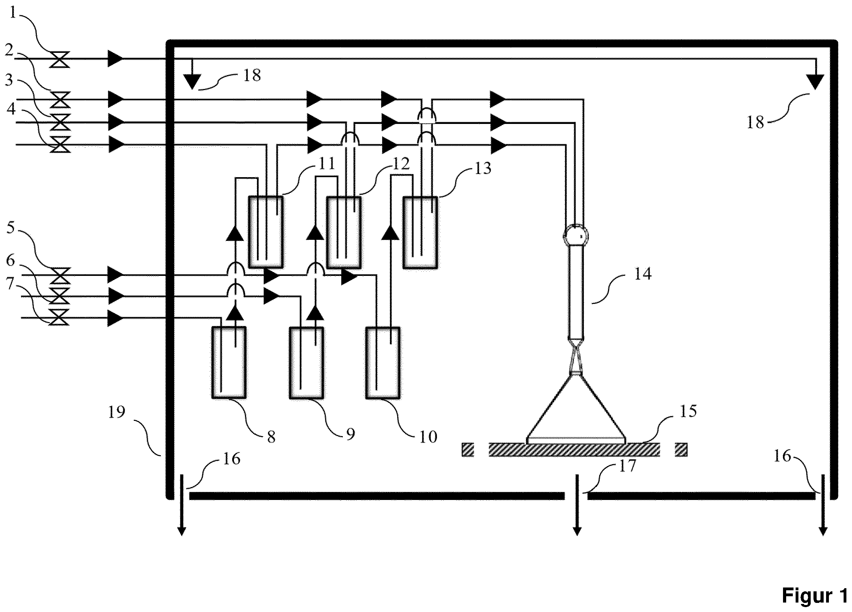

Wie in Figur 1 schematisch dargestellt, umfasst der SRA-CVD-Reaktor im Einzelnen:
1. Eine Dichtkammer (19), in der eine oder eine Reihe von Abscheidevorrichtungen (14) sowie Katalysator- und Reaktanten-Zuführungssysteme (1 bis 13) installiert sind. Die Kammer (19) ist zum einen von unten an ein Absaugsystem angeschlossen, das dazu dient, die Reaktionsnebenprodukte nach der Neutralisation abzuführen. Zum anderen ist die Dichtkammer (19) über entsprechende Adapter in den Wänden mit den zuführenden Rohrleitungen und elektrischen Anschlüssen verbunden. Außerdem sind an den gegenüberliegenden Seiten der Dichtkammer (19) zwei Förderräume außen angebracht, um die Beschickung mit den Substratvorprodukten und deren Entnahme nach der Beschichtung zu ermöglichen. Jeder Förderraum ist mit einem Spülsystem sowie zwei abgedichteten Türen ausgestattet, die sich automatisch abwechselnd öffnen und schließen. Das Öffnen und Schließen der Türen ist so eingestellt, dass die Gase während des Betriebs nicht aus dem Kammervolumen entweichen können. Das Be- und Entladen des Substrats kann mit Hilfe eines computergesteuerten Systems vollständig automatisiert werden. Der gesamte SRA-CVD-Reaktor wird vorzugsweise in einem Reinraum untergebracht und betrieben, in dem die Reinheit der verarbeiteten Ausgangsstoffe und damit eine widerstandsfähige Beschichtung gewährleistet ist. In der Dichtkammer (19) wird pro Beschichtungsvorgang ein Substrat verarbeitet, wobei ein unbeschichtetes Substratvorprodukt im Beladeraum aufbewahrt und ein beschichtetes über den Entladeraum entladen wird.
2. Reaktanten-Zuführungssysteme, bestehend aus:
   - Bubblern (8, 9) zur Umwandlung der Reaktantenvorläufer aus der flüchtigen Flüssigkeit, einschließlich der Halogenide und NH₃, in die Dampfphase unter Verwendung eines trockenen Inertgases,
   - Verdampfern zur Extraktion von Halogeniddämpfen aus ihren jeweiligen festen / verflüssigten Quellen mit Hilfe von Chloridhalogenid, Bromidhalogenid- oder lodidhalogenidgas, z. B. Cl₂, HCl, HBr und anderen,
      und
   - Verdünnungsbehältern (11, 12), in denen ein trockenes Inertgas verwendet wird, um den von den Verdampfern und Bubblern angetriebenen Reaktantengasstrom zu verdünnen, um damit die Reaktanten-Molkonzentration einzustellen.
      Die Anzahl der verwendeten Verdampfer, Bubbler und Verdünnungsbehälter ist abhängig von der gewünschten Schicht- oder Schichtstapelzusammensetzung. Jedes Teil dieser Systeme sollte bei einer konstanten Temperatur gehalten werden, die vom Dampfdruck der Reaktanten und der erforderlichen Durchflussrate abhängt.
3. Ein Katalysator-Zuführungssystem, bestehend aus einer Gasvorratsflasche oder einem Bubbler (10), um Katalysatoren wie Cl₂, NH₃, HCl, HBr usw. in einer genauen Konzentration bereitzustellen. Die Konzentration wird durch eine Verdünnungsvorrichtung bestimmt, die der für die Hauptreaktanten verwendeten ähnlich ist. Dazu wird der Katalysatorstrom in einen Verdünnungsbehälter (13) geleitet, in die ein seitlicher Strom eines trockenen Inertgases eingeleitet und mit dem Katalysator vermischt wird. Die Temperatur dieses Systems sollte durch leichtes Erhitzen eingestellt werden.
4. Eine Heizvorrichtung mit einem eingebauten Widerstands-Silikonmantel oder ähnlichem, mit der die Temperatur der Bubbler, Verdampfer, Verdünnungsbehälter und des Katalysator-Zuführungssystems während des Abscheide-Prozesses präzise gesteuert werden kann.
5. Mindestens eine SRA-CVD-Abscheidevorrichtung (14), die optional mit der so genannten Fused Deposition Modeling-Technologie, auch dreidimensionaler (3D) Druck genannt, hergestellt ist. Dadurch lassen sich maßgeschneiderte Formen für verschiedene Substratoberflächen erzielen. Die Abscheidevorrichtung (14) kann aus allen Arten von thermoplastischen Werkstoffen hergestellt werden. Ein schlitzförmiger Auslass, der in einer Substrathalterung (15), mit der die Abscheidevorrichtung (14) verschließbar ist, ausgebildet ist, ist über einen Adapter mit einstellbarer Öffnungsgröße mit den Auslassöffnungen (16, 17) der Dichtkammer (19) verbunden, wodurch der Auslassstrom genau gesteuert werden kann. Weitere Einzelheiten werden später beschrieben.
6. Thermisch isolierte Rohrleitungen für die Zufuhr der gasförmigen Reaktanten bei konstanter Temperatur durch alle Reaktorteile. Weitere Rohrleitungen sind angeschlossen, um das Innere der Dichtkammer (19) vor und während der Abscheidung mit trockenem Inertgas zu spülen, das aus einem entsprechenden Tank bereitgestellt wird.
7. Digital gesteuerte Ventile und Massendurchflussregler (MFCs) (1 bis 7), die in einer einzigen Baugruppe integriert sein können. Sie dienen der präzisen Einstellung und Messung der Durchflussmenge der Gasströme in jeder Rohrleitung und der Übertragung der Daten zur Visualisierung auf einem Computerbildschirm. Diese Baugruppen sind auch in Notfällen funktionsfähig, z. B. wenn eine Störung auftritt. Im Störfall werden die automatischen Ventile sofort geschlossen, so dass kein Gas in die Dichtkammer (19) gelangt.
8. Schritt-Mikropumpen, die für die Dosierung extrem kleiner Mengen, vorzugsweise von 0,05 - 0,1 µl/s, der Halogenid-Reaktionspartner aus einem seitlichen Vorrat in die entsprechenden Bubbler (8, 9) zuständig sind. Die Schritt-Mikropumpen werden digital angesteuert, so dass über die Zeit konstant gleichmäßige Flüssigkeitsmengen dosiert werden. Die fördernden Rohrleitungen sind thermisch isoliert. Die Halogenid-Vorräte müssen nicht beheizt werden, auch nicht, wenn sie nach ihren Bubblern oder Verdampfern weitergeleitet werden.
9. Sensoren zur Messung der relativen und absoluten Feuchtigkeit (RH bzw. AH) sowie der Temperatur an verschiedenen Stellen des SRA-CVD-Reaktors. So zum Beispiel in dem Hydrolyse-Bubbler, in den Halogenid-Verdampfern und -Bubblern, in den Verdünnungsbehältern, in dem Katalysator-Bubbler und dem zugehörigen Verdünnungsbehälter, in der SRA-CVD-Abscheidevorrichtung (14) und an ihrer Substrathalterung (15) sowie an verschiedenen Stellen des Reaktorvolumens und der Förderräume. Wenn sowohl die Temperatur- als auch Feuchtigkeitswerte erfasst werden sollen, können eingebaute Feuchtigkeits- und Temperatursensoren vorgesehen werden. Es ist anzumerken, dass die Silikonmäntel und andere Heiz-/Kühlvorrichtungen mit dem Computer verbunden sind, um ihre entsprechende Temperatur über die Betriebszeit zu regeln und zu visualisieren.
10. Eine Digitalkamera, die im Inneren der Abscheidevorrichtung (14) installiert ist, um während des Abscheideprozesses den Fortschritt der Schichtabscheidung zu überwachen. Dies kann beispielsweise durch den Anschluss eines Endoskops an einen Computer realisiert werden, mit dessen geeigneter Software Live-Aufzeichnungen und Videos oder Fotos zur Dokumentation erfasst werden können.
11. Ein Neutralisationssystem, das an die Abgasleitung angeschlossen ist und in dem die Reaktionsnebenprodukte gesammelt werden und mit neutralisierenden Materialien in fester oder flüssiger Phase in Wechselwirkung treten. Darüber hinaus dient dieses System der Vorfilterung der Abgase von jeglichen Partikelverunreinigungen, die nach dem Passieren der Dichtkammer auftreten könnten.

Die erfindungsgemäße SRA-CVD-Abscheidevorrichtung ist so konzipiert, dass sie wahlweise vertikal oder in anderen Richtungen betrieben werden kann. Wird sie vertikal betrieben, vermischen sich die Reaktanten auf dem Weg nach unten und interagieren mit dem Substrat an ihrem unteren Ende, welches durch die Substrathalterung definiert ist, bevor der obere Teil der Vorrichtung angehoben wird, so dass die Nebenprodukte durch den Auslass abgelassen werden können.

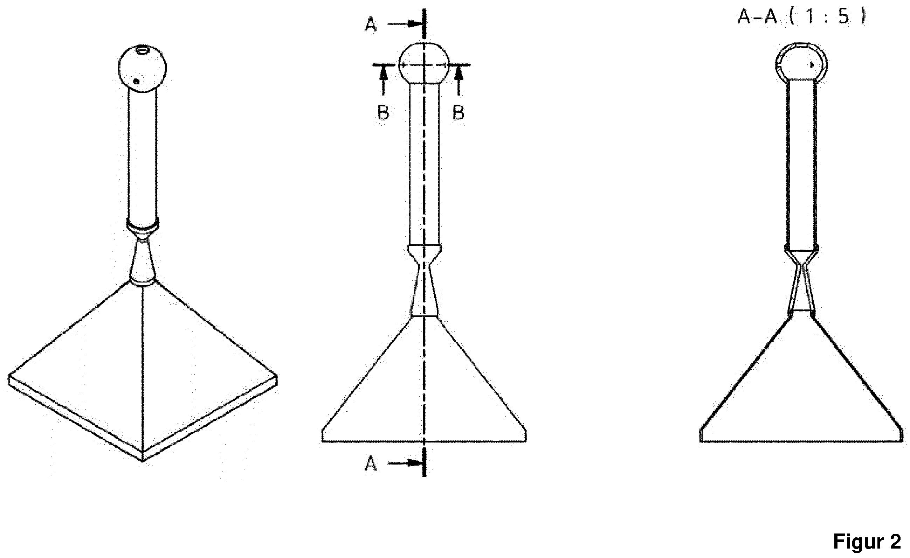

Die in Figur 2 schematisch dargestellte SRA-CVD-Abscheidevorrichtung (14) besteht zusammengefasst aus vier Bestandteilen, die kompakt von oben nach unten wie folgt verbunden sind:
1. Eine statische photoempfindliche Gasmischeinheit, die mit einer kugelförmigen Einlasskappe an der Oberseite ausgestattet ist.
2. Eine konvergent-divergente Düse, die am Ausgang der photoaktivierenden Gasmischeinheit angebracht ist.
3. Ein teilweise pyramidenförmiger, in Strömungsrichtung divergenter Expansionsverteiler mit einem Verhältnis von 1:8 zwischen dem Einlass- und dem Auslassbereich.
4. Eine Substrathalterung (15) mit schlitzförmiger Auslassöffnung am Umfang, an bzw. auf der verschiedene Substratformen befestigt werden können.

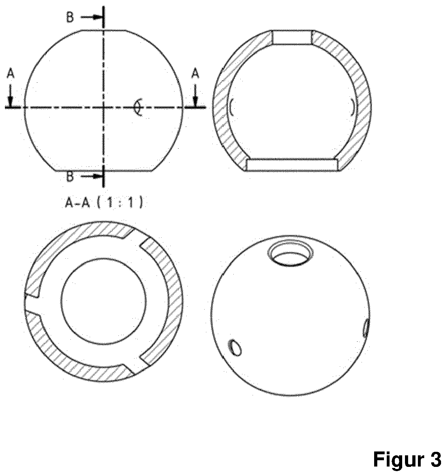

Nachfolgend werden die Aufgaben und die Funktionsweise der einzelnen Bestandteile der Abscheidevorrichtung ausführlicher erläutert: Die kugelförmige Einlasskappe (Figur 3) weist drei Durchlassöffnungen auf, die an ihrem größten Umfang derart positioniert sind, dass sie in der horizontalen Ebene um einen definierten Winkel geneigt sind. Die Reaktanten-Gase werden mit einer laminaren Strömung eingeleitet und beim Eintritt in die kugelförmige Einlasskappe vor allem zyklonal vorvermischt. Diese zyklonale Vorvermischung reicht jedoch nicht aus, um ein homogenes Gasgemisch herzustellen, das mit der Substratoberfläche in Wechselwirkung treten soll.

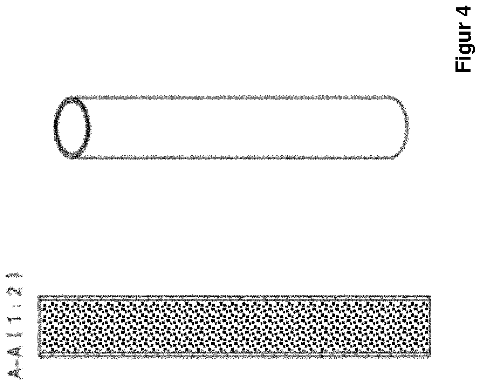

Die in Figur 4 gezeigte photoempfindliche Gasmischeinheit besteht aus einem kompakten Zylinder, in den ein poröser Körper aus z. B. Titandioxid, mit Titandioxid beschichtetem Quarz/SiO₂, ZnO, mit ZnO beschichtetem Quarz/SiO₂, einer Mischung aus beiden, mit photoempfindlichem Material beschichteten Polymer oder anderen photoempfindlichen, genauer gesagt UV- und IR-empfindlichen, dielektrischen Oxiden oder Halbleitern eingebracht wurde. Weiterhin sind UV- und IR-Strahlungsquellen in der Umgebung des Zylinders installiert, wobei die Wellenlänge der UV-Strahlung im Bereich zwischen 115 und 300 nm gewählt wird.

Der poröse Körper kann durch Sintern eines oder mehrerer der oben genannten Materialien hergestellt werden, so dass er die Form eines Gitters oder aus zufällig gepackten, mikro- bis millimetergroßen Partikeln oder Röhren erhält. Bei der Verwendung von UV-unempfindlichen Material als Kernobjekt, z. B. SiO₂, wird dieses mit einer kolloidalen Schicht aus UV-empfindlichen Materialien beschichtet. Mit Hilfe der UV-Strahlung werden die Reaktanten-Moleküle in der Abscheidevorrichtung bzw. auf der Substratoberfläche in ihre Radikale dissoziiert. Dabei sind die UV-Strahler nicht nur auf die photoempfindliche Gasmischeinheit, sondern auch auf die Substrathalterung gerichtet.

Außerdem absorbiert der poröse Körper eine IR-Strahlung, wodurch er auf eine definierte Temperatur, vorzugsweise im Bereich zwischen 40 und 80 °C, erwärmt wird. Dies ist eine Voraussetzung dafür, dass die weitere Reduktion der IMPs zu fertigen Oxidprodukten in der Abscheidevorrichtung (14) unterdrückt wird. Die Temperatur der Substrathalterung (15) wird dagegen auf Raumtemperatur oder darunter eingestellt, so dass eine Oberflächenreaktionsabscheidung auf der Substratoberfläche ohne Oxidpartikelkontaminationen erfolgen kann.

Die Gitterstruktur oder die zufällig gepackten Partikel/Röhrchen des porösen Körpers weisen Leerstellen in den Zwischenräumen auf. Die Größe der Leerstellen ist dabei ungleichmäßig und wird in erster Linie durch die Größe der Partikel/Röhrchen bestimmt. Diese Ungleichmäßigkeit ist äußerst vorteilhaft für die Erzeugung von Turbulenzen, sobald die laminar strömenden Reaktanten-Gase den porösen Körper passieren. Dies ist darauf zurückzuführen, dass der Gasstrom während der Passage vorbei an den feinen Partikeln oder Röhrchen ständig seine Richtung ändert. Beim Umströmen der Partikel oder Röhrchen teilt sich der Gasstrom zudem auf und dehnt sich in einem großen Bereich aus. Das Phänomen der einen Partikel umströmenden Strömung wird durch das Bernoulli-Prinzip und die Navier-Stokes-Gleichungen für nicht viskose und viskose Strömungen gut erklärt. Die Multiplikation der getrennten Stromlinien ermöglicht ihre anisotrope Ausdehnung im porösen Körper, wodurch eine ausreichende Durchmischung zwischen den verschiedenen Reaktanten-Gasen erreicht wird.

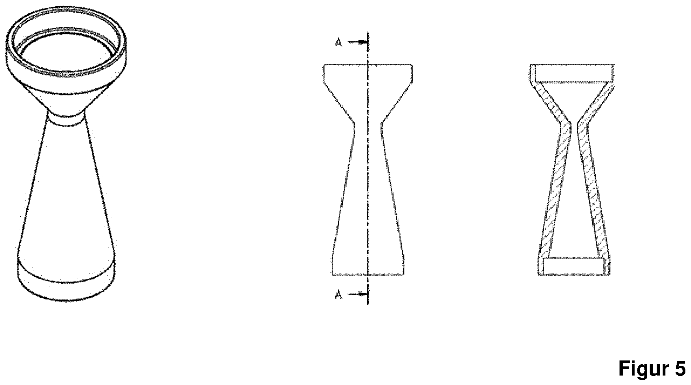

Die konvergent-divergente Düse, die in Figur 5 gezeigt ist, kann beispielsweise einen runden Querschnitt aufweisen, dessen Einlassdurchmesser dem Auslassdurchmesser der photoempfindlichen Gasmischeinheit entspricht. Diese Durchmesser sind in der betreffenden Figur nicht dargestellt. Die Düse wird zur Erzeugung von Strömungsumlenkungen, Turbulenzen und Unterdrückung von Rückströmungen am Auslass der Gasmischeinheit verwendet. Dadurch wird die Expansion des Gasgemisches gefördert und seine gleichmäßige Verteilung über den gesamten, unterhalb der Düse befestigten Expansionsverteiler erreicht.

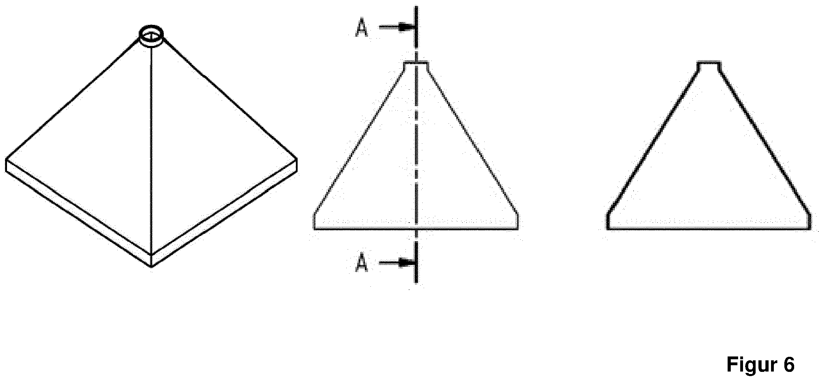

Der Expansionsverteiler, der eine teilweise pyramidenförmige Form aufweist, die in vertikaler Richtung bis zum Substrat divergiert, dient dazu, das Gasgemisch gleichmäßig auf der Substratoberfläche (beispielsweise eine Fläche von bis zu 300 × 300 mm²) zu verteilen (s. Figur 6). Die Abmessungen des Verteilers sind so gewählt, dass die verschiedenen Reaktanten-Moleküle nicht nur in der stationären Mischeinheit, sondern auch untereinander und mit der Substratoberfläche ausreichend kollidieren können. Dadurch wird die Stöchiometrie des auf die Substratoberfläche auftreffenden Gasgemisches weiter optimiert.

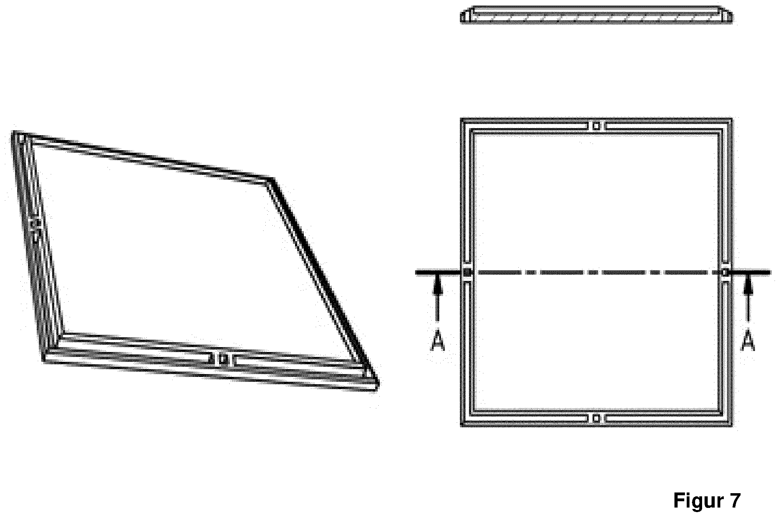

Die Substrathalterung (15) (Figur 7), auf oder an der die zu beschichtenden Substrate befestigt werden können, wird von den anderen, bereits beschriebenen Bestandteilen der SRA-CVD-Abscheidevorrichtung überdeckt. Sie hat beispielsweise eine quadratische Form mit einer schlitzförmigen Öffnung an ihrem Umfang, die mit dem Absauge- bzw. Neutralisationssystem verbunden ist und als Auslass dient. Dieser Auslass ist so gestaltet, dass er durch eine nach oben gerichtete Stufe an den äußersten Kanten der Halterung gerillt ist, die den Spalt zwischen dem Verteilerauslass und der Substrathalterung umgeben. Darüber hinaus ist die Stufe von außen in einem definierten Winkel abgeschrägt. Diese Konstruktion ist nicht nur für die Beseitigung des Gassogs durch den Auslass von Bedeutung, sondern auch für die Vermeidung von Wirbeln an den Substratkanten sowie an dem engen Spalt zwischen dem Verteilerauslass und der Halterung. Die Öffnungs- und Stufendurchmesser sind in den beigefügten Figuren nicht dargestellt.

Die Temperatur der Substrathalterung (15) wird mit Hilfe einer differentialthermoelektrischen Vorrichtung in einem Bereich von -20 bis 60 °C eingestellt. Mit der Substrathalterung (15) wird zudem das Volumen der Abscheidevorrichtung (14) teilweise verschlossen, so dass die Zeit der Rezirkulation des Gasgemischs innerhalb dieses Volumens verlängert wird. Darüber hinaus ist sie ein Strömungshindernis am unteren Ende des Verteilers und verursacht zahlreiche zusätzliche Turbulenzen im gesamten Verteiler-Volumen. Dies führt wiederum zu einer verstärkten Kollision zwischen den verschiedenen Gasmolekülen, wodurch die Stöchiometrie des Gasgemischs und die effiziente Interaktion mit der Substratoberfläche weiter verbessert werden.

Nachfolgend wird die Vorbereitung und Funktion eines erfindungsgemäßen SRA-CVD-Reaktors näher erläutert.

In einem ersten vorbereitenden Schritt wird die Dichtkammer (19) mit einem trockenen Inertgas gespült, um die feuchte Luft aus ihrem Volumen zu verdrängen. Dies wird durch die Einstellung einer maximalen Absaugleistung für etwa 15 min in Kombination mit einer hohen Durchflussrate des Inertgases, vorzugsweise 15 - 20 l/min, ermöglicht. Das Inertgas wird über einen Rohrleitungsverteiler (18) auf das gesamte Kammervolumen verteilt. Dies ist notwendig, um die Bildung von Oxidpartikeln und die Kondensation von Dämpfen, die aus der Abscheidevorrichtung (14) entweichen könnten, im Kammervolumen bzw. an den Innenwänden zu verhindern. Nachdem die Dichtkammer (19) ausreichend gespült wurde, werden die Absaugleistung und die Durchflussrate des Spülgases gedrosselt, so dass der darauffolgende Abscheidungsprozess ohne Schaden möglich ist. Durch diesen Vorbereitungsschritt wird das Volumen in der Dichtkammer (19) trocken gehalten und der Druck in ihrem Inneren leicht unter dem Umgebungsdruck eingestellt. Dadurch wird verhindert, dass reaktive Gase aus der Dichtkammer (19) entweichen, so dass ein sicherer Betrieb gewährleistet ist, wobei die niedrige Absaugleistung das gesamte Kammervolumen mit Ausnahme des Innenraums der SRA-CVD-Abscheidevorrichtung betrifft, so dass während des Abscheidungsprozesses die Gasentleerung nicht begünstigt wird.

Im zweiten vorbereitenden Schritt wird die Durchflussmenge des Trägergases in den Rohrleitungen, mit dem die Reaktantengase transportiert werden, eingestellt und stabilisiert. Je nach gewünschter Abscheiderate variiert diese Durchflussmenge von 0,1 bis zu einigen Litern pro Minute, vorzugsweise 2,5 l/min für jede Rohrleitung. Je höher dieser Gasdurchsatz ist, desto besser ist die Gasdurchmischung in der Abscheidevorrichtung und desto zuverlässiger ist die Stöchiometrie der abzuscheidenden Schicht.

Schließlich wird noch das Temperaturprofil aller Bestandteile des SRA-CVD-Reaktors unter Beachtung des Gasdrucks der einzelnen Reaktanten und letztlich der erforderlichen Abscheidungsrate eingestellt. Dabei werden die Dichtkammer (19) und die Rohrleitungen auf Raumtemperatur gehalten. Die Abscheidevorrichtung (14) wird auf eine Temperatur zwischen 40 und 80 °C erwärmt und die Substrathalterung (15) auf eine Temperatur zwischen -20 und 60 °C eingestellt. Während die Temperatur der Hydrolyse- und Katalysatorbubbler zwischen 20 und 35 °C gehalten wird, wird der Halogenid-Bubbler auf eine Temperatur zwischen 10 und 30 °C und der Halogenid-Verdampfer auf eine Temperatur zwischen 40 und 70 °C reguliert. Es ist von entscheidender Bedeutung, dass in den Rohrleitungen eine konstante Temperatur aufrechtgehalten wird, um die Kondensation von Dampf zu verhindern und somit die Abscheidungsrate präzise regulieren zu können.

Nach Einstellung der oben genannten Randbedingungen werden die Gase des Katalysators und der Reaktanten in den jeweiligen Bubblern und/oder Verdampfern mit konstanter Temperatur hergestellt und von dem in den Rohrleitungen strömenden Inertgas in die entsprechenden Verdünnungsbehälter, in denen ihre jeweiligen Konzentrationen präzise eingestellt werden, geleitet. Die Gase der Halogenide werden bei konstanter Temperatur aus einem entsprechenden Metallreservat unter Einwirkung von Cl₂, Br₂, I₂, HCl, HBr, oder HI-Gas erzeugt, bevor sie in ihre Verdünnungsbehälter geleitet werden.

Die Behandlung der zugehörigen Nebenprodukte, z.B. H₂-Gas, wird in diesem Erfindungsvorschlag nicht weiter erläutert.

Die auf diese Weise erzeugten Gasvorläufer werden anschließend zu den entsprechenden Durchlassöffnungen der kugelförmigen Einlasskappe der SRA-CVD-Abscheidevorrichtung (14) geleitet, wobei die Temperaturen der Gasvorläufer identisch mit denen der zugehörigen Verdünnungsbehälter sind. Die molekulare Zersetzung des gasförmigen H₂O im Inneren der SRA-CVD-Abscheidevorrichtung (14) kann dank der Cl₂-verstärkten Katalyse und/oder der Photokatalyse, die in der Gasmischeinheit, deren TiOₓ/ZnO-Oberflächen vorzugsweise mit einer geeigneten UV- und IR-Strahlung beaufschlagt werden, effizienter realisiert werden.

Die UV-Strahlung trifft dabei auf das gesamte Volumen der Abscheidevorrichtung (14) einschließlich der Gasmischeinheit und der Substratoberfläche, während die IR-Strahlen auf das gesamte Volumen der Abscheidevorrichtung (14) mit Ausnahme des Substrats und der Grenzschicht der darauf niedergeschlagenen Reaktantengase einwirken.

Für die IR-Strahlung wird bevorzugt ein zum Substrat gerichteter Temperaturgradient mit einem definierten Profil von hoch zu niedrig eingestellt. Schließlich führt die gesamte Photoaktivierung zur Erzeugung von OH⁻- und H3O⁺/O⁺-Ionen oder entsprechenden Radikale in den Gasmischungen und auf der Substratoberfläche. Die Bildung der reaktiven Radikale stimuliert die Hydrolyse-Reaktion erheblich und beseitigt nachweislich die Verunreinigungen in den abgeschiedenen Schichten. Obwohl die Hydrolyse-Reaktion der vorgenannten Halogenide extrem abrupt abläuft (im Bereich von Millisekunden bei Raumtemperatur), wird sie unabhängig von der Dauer der Durchmischung der Reaktanten auf die Substratoberfläche verschoben. Dies wird dadurch ermöglicht, dass das Substrat in einem Bereich von -20 bis 60 °C temperiert wird, während das umschließende Volumen der Abscheidevorrichtung (14) aufgrund des IR-Strahlungsprofils auf bis zu 80 ºC erwärmt wird. Daher findet die Hydrolyse und damit verbunden die Schichtbildung ausschließlich auf der Substratoberfläche statt, wobei die Temperatur des Substrates durch das abgeschiedene Schichtmaterial bestimmt wird und keine zusätzliche thermische Aktivierungsenergie erforderlich ist, um die Reaktion einzuleiten und zu beschleunigen.

Im Gegensatz zu den aus dem Stand der Technik bekannten Lösungen werden die Gasvorläufer in der Abscheidevorrichtung (14), die sich durch ein relativ gut abgedichtetes Volumen auszeichnet, über einen relativ langen Zeitraum, der im Wesentlichen der Abscheidungsdauer der einzelnen Schichten entspricht, zersetzt und vermischt. Dadurch wird ein homogenes Gasgemisch erzeugt, ohne dass sich Oxid-oder Oxinitrid-Zwischenprodukte bilden, bevor sie die Substratoberfläche erreichen. Das homogene Gasgemisch trifft anschließend kontinuierlich auf die Substratoberfläche und die Radikale des Gasgemisches treten miteinander und mit der Substratoberfläche in Wechselwirkung. Infolgedessen bildet sich die gewünschte Oxid- oder Oxinitridschicht und die sich bildenden Nebenprodukte werden nach außen abgegeben. Die Schichtdicke nimmt in Abhängigkeit von der Verweilzeit des Gasgemisches in der Reaktionszone und der Injektion der Reaktanten zu.

Das Maß der Hydrolyse-Dissoziation in der Gasphase ist in Verbindung mit der langfristigen Gasdurchmischung von Bedeutung für die Überwindung der geringen mittleren freien Weglänge der Moleküle im SRA-CVD-Verfahren. Die Verweilzeit und die Rezirkulation der Reaktanten in der Abscheidevorrichtung haben vorteilhafterweise keine Auswirkungen auf die Belastbarkeit der abgeschiedenen Schichten. Dies ist darauf zurückzuführen, dass die IMPs in dem die Substratoberfläche umgebenden Volumen der Abscheidevorrichtung nicht zu Endprodukten reduziert werden und keine Verunreinigungen in den Schichten verursachen. Folglich entfällt die homogene, durch Moleküldiffusion begrenzte Reaktion, und das SRA-CVD-Verfahren kann als heterogen kontrollierte Reaktion eingestuft werden.

Es ist erwähnenswert, dass die Kammerabsaugung während des Abscheideprozesses bei einer geringen Durchflussrate erfolgen kann, da lediglich das inerte Spülgas in der Dichtkammer vorhanden ist und nur ein sehr geringes Volumen der reaktiven Gase aus der Abscheidevorrichtung entweichen kann. Nach einem kontinuierlichen Abscheideprozess wird die Kammerabsaugung vollständig geöffnet, indem der obere Teil der Abscheidevorrichtung ohne die Substrathalterung angehoben und die Durchflussmenge erhöht wird, so dass die Nebenprodukte schnell abgeleitet werden. Die gasförmigen Nebenprodukte werden in dem entsprechenden System, das in die externe Abgasleitung integriert ist, gefiltert und neutralisiert.

Die auf diese Weise abgeschiedenen Schichten sind porenfrei und weisen eine kontrollierbare Oberflächenrauhigkeit von bis zu 0,4 nm oder sogar weniger auf. Andererseits kann die Oberflächenrauhigkeit, wenn dies beabsichtigt ist, extrem hoch sein, z. B. im Bereich von einigen hundert Nanometern. Darüber hinaus erhöht sich die Abscheiderate in dem Maße, in dem die Bildung von IMP's im Inneren der Abscheidevorrichtung unterbunden wird, so dass auch der Verbrauch von Vorläufer-Material reduziert werden kann.

Soweit nicht anders angegeben, werden Oxid- oder Oxinitrid-Materialien unter Umgebungsbedingungen durch Hydrolyse von Halogeniddämpfen in Gegenwart eines CI-Katalysators oder / und UV- und IR-Anregung in Form von elektrisch leitfähigen oder dielektrischen Schichten chemisch abgeschieden. Die abgeschiedenen Schichten zeichnen sich durch eine nahezu identische Stöchiometrie, einen breiten Bereich (von niedrig bis hoch) der Durchbruchsspannung, einen hohen Widerstand gegen alkalische und saure Ätzmittel, einen breiten Bereich (von niedrig bis hoch) der Beschichtungsdichte gegen die Diffusion von Verunreinigungen oder Metalllegierungen, hohe Passivierungseigenschaften, hohe Reflexions-/Antireflexionseigenschaften und eine zufriedenstellende Gleichmäßigkeit der Schichtdicke und Stufenbedeckung aus. Im Gegensatz zu den Schichten, die mit einer herkömmlichen Hydrolyse von Halogeniden unter atmosphärischen Bedingungen hergestellt werden, sind die mit dem vorgeschlagenen Verfahren hergestellten Schichten heterogen, stöchiometrisch und konform abgeschieden und eignen sich hervorragend für verschiedene Anwendungen, beispielsweise in der Optik oder Halbleitertechnik, bei denen robuste Eigenschaften, wie z.B. elektrische, optische, mechanische, chemische und Grenzflächeneigenschaften, von wesentlicher Bedeutung sind. Darüber hinaus wird eine zufriedenstellende Gleichmäßigkeit der Schichtdicke auf etwa 300 × 300 mm² großen Substraten erreicht.

Neben dem neuartigen Verfahren zur Abscheidung charakteristischer Oxid-oder Oxinitridschichten bezieht sich diese Erfindung auch auf eine Vorrichtung, nämlich einen SRA-CVD-Reaktor, der für die Abscheidung von dünnen Schichten auf nahezu allen Substratmaterialien geeignet ist. Diese Vorrichtung ist für Abscheidungen bei Umgebungsdruck oder unter oder leicht über diesem Druck geeignet. Darüber hinaus ist sie für das Mischen und Reagieren von Dämpfen mit Hydrolanregung durch einen Katalysator, nämlich Cl, oder UV-Strahlung geeignet. Der gesamte Reaktor besteht im Wesentlichen aus statischen Teilen und kann vollständig aus einem beliebigen Material bestehen, das weder korrodiert noch mit den entstehenden Produkten oder den entstehenden Nebenprodukten reagiert. Je nach Temperatur kann der Reaktor aus Teflon, teflonbeschichteten Kunststoffen, Oxiden oder anderen hydrophoben, korrosionsbeständigen Materialien bestehen. Die Gasverdünnungsbehälter sind wesentliche Bestandteile des SRA-CVD-Reaktors, da sie für die hochpräzise Einstellung der Teilchenkonzentrationen verantwortlich sind.

Mit dem vorgeschlagenen Verfahren können die Mengen der Reaktionsmoleküle und Katalysatoren genau eingestellt werden. Es findet eine langfristige Durchmischung der Gasvorläufer ohne die Bildung von Zwischen- oder Endprodukten und eine ausreichende Ionisierung und Dissoziation der Moleküle in der Gasphase statt, wobei bekannte Sofortreaktion zwischen dem Halogenid und dem Hydrolysemittel in unerwünschten Bereichen der Abscheidevorrichtung unterdrückt und eine verlängerte Verweilzeit des Gasgemisches in der Reaktionszone erreicht wird. Damit können die langen mittleren freien Weglängen der Moleküle, welche die Halogenidhydrolyse unter Umgebungsbedingungen negativ beeinflusst, überwunden und somit perfekt stöchiometrische Beschichtungen realisiert werden.

Der Übergang von einer homogenen Reaktion zu einer heterogenen Oberflächenreaktion bei der Halogenidhydrolyse gemäß dem vorgeschlagenen Verfahren wird durch die Bereitstellung eines Temperaturgradienten zwischen dem Gasgemisch im Volumen der Abscheidevorrichtung und der Substratoberfläche erreicht. Dieses Temperaturprofil liefert genügend Wärmeenergie, um die bekanntermaßen exotherme Halogenidhydrolysereaktion in den unerwünschten Bereichen der Abscheidevorrichtung umzukehren. Dies führt dazu, dass sich die IMPs in den unerwünschten Bereichen bilden und zersetzen, während sie in den erwünschten Bereichen (Substratoberfläche) Endprodukte bilden dürfen.

Die Anwendung der heterogenen Oberflächenreaktion ist äußerst wichtig, wenn es darum geht, sehr charakteristische Schichten für präzise und raue Anwendungen abzuscheiden. Die Erzeugung derartiger robuster Schichten hängt von der Interaktionszeit, der zugeführten Energie und dem Weg der Reaktionsmoleküle unter Umgebungsdruck ab. Darüber hinaus erfolgt die Einleitung und Fortführung der Halogenidhydrolyse ohne thermische Aktivierungsenergie oder evakuierte CVD-Anlagen, jedoch mit chemischer oder/und photokatalytischer Katalysation.

Dies sind die größten Herausforderungen für konventionelle CVD-Technologien, die unter Umgebungsdruck betrieben werden und von denen bekannt ist, dass sie als Folge der molekularen diffusionsgesteuerten Reaktion eine Materialagglomeration vor der Substratoberfläche hervorrufen. Abhilfe schafft das einfache SRA-CVD-Verfahren und die dazugehörige Reaktorkonfiguration, die Gegenstand dieser Erfindung sind. Im Stand der Technik wurde vielfach gezeigt, dass chemische Vorläufer, die mit den vorliegend vorgeschlagenen identisch sind, separat, alternativ oder in unmittelbarer Nähe der Substratoberfläche eingebracht werden, um eine Agglomeration zu verhindern. Dadurch wird die Kontaktzeit zwischen den reaktiven Spezies tendenziell weiter verringert. Alternativ dazu wird mit der vorliegenden Erfindung ein zuverlässiges Regime interagierender Moleküle offenbart, die in der Regel ungeeignet sind, weit entfernt von den zu beschichtenden Oberflächen in Kontakt zu treten, indem eine relativ langfristige Durchmischung im gesamten Apparatevolumen vorgesehen ist, ohne die Qualität der abgeschiedenen Schicht zu senken. Die Verzögerungszeit sowohl des Gasdurchmischungsprozesses als auch der Reaktionsunterdrückung im oberen Teil der Abscheidevorrichtung ist nachweislich funktionell unbegrenzt, solange die umgebenden Randbedingungen konstant bleiben. Die Kollisionshäufigkeit der Reaktionsmoleküle und ihre Zersetzung sind bei dem vorgestellten Verfahren besser als bei herkömmlichen CVD-Verfahren bei Umgebungsdruck. Dies ist darauf zurückzuführen, dass eine UV-/IR-Strahlung und eine lange Molekül-/lonen-Rezirkulation dazu verwendet wird, die kurze mittlere freie Weglänge zwischen den reaktiven Spezies perfekt zu überwinden.

Die SRA-CVD-Abscheidung gewährleistet die Reproduzierbarkeit der Schichteigenschaften und der Abscheidungsraten bei gleichen Betriebsbedingungen, während bei anderen chemischen Abscheidungsverfahren zwei oder mehr Reaktionsgase in die Kammer eingeleitet werden, um deren gesamtes Volumen auszufüllen, und auf mehreren parallelen oder seriellen Abscheidevorrichtungen äquidistante Substrate zu beschichten. Auf diese Weise kommt es zu einer Verringerung der Reaktantenkonzentration im Gasstrom in der gesamten Kammer und damit zu inkonstanten Abscheidungsraten und Schichteigenschaften.

Die Hydrolyse von Halogenidverbindungen zur Herstellung von Oxidschichten wird in der Regel mit ALD und CVD durchgeführt, bei denen die Dämpfe der Reaktanten nacheinander zugeführt werden. Dabei ist die gleichzeitige Anwesenheit von Halogenid- und H₂O-Gasen in der Abscheidekammer bei herkömmlichen Abscheideverfahren unzulässig, weil dadurch eine Reaktion in der Gasphase abläuft und somit eine sofortige Produktbildung erfolgt. Es war bisher nicht offensichtlich, dass eine relativ hohe Konzentration von Halogeniden und Hydrolysemitteln gleichzeitig in einem Volumen vorhanden sein kann, ohne dass es zu einer Reaktion kommt. Auf den ersten Blick könnte daher eine relativ lange Vermischung der Halogenid- und H₂O-Gase zur Bildung von Agglomeraten (Verunreinigungen) im Apparatevolumen und damit zu einer mangelhaften Schichtqualität führen. Reproduzierbare Ergebnisse zeigten jedoch, dass mit der SRA-CVD-Abscheidevorrichtung, die ein nahezu geschlossenes Volumen aufweist, in Kombination mit der strahlungsinduzierten Unterdrückung der Reaktion in der Gasphase der Kontaminationseffekt eliminiert wird und die abgeschiedenen Schichten sich durch eine hohe Qualität und Stabilität für viele Anwendungen auszeichnen.

Das Temperaturprofil der Reaktionszone im SRA-CVD-Abscheidevorrichtung ist so gewählt, dass die Substrathalterung die niedrigste Temperatur unter den übrigen Geräteteilen aufweist. Dies steht im Gegensatz zu den herkömmlichen CVD/ALD-Temperaturprofilen, bei denen die Substrathalterungen bzw. bei vielen Systemen das gesamte Kammervolumen im Wesentlichen auf hohe Temperaturen eingestellt sind. Die hohe Temperatur ist bekanntermaßen wesentlich, da sie eine ausreichende Aktivierungsenergie liefert, um die Reaktion auf der Substratoberfläche einzuleiten und aufrechtzuerhalten. Aus diesem Grund wird in CVD-Reaktoren mit kalten Wänden, in denen eine Art der heterogenen Oberflächenreaktion abläuft, die Abscheidung selektiv auf das Substrat beschränkt. Bei dem neu entwickelten Oberflächenreaktionsverfahren ist die gemeinsame Aktivierungsenergie, die für die Einleitung der Reaktion und für die Schichtabscheidung auf der Substratoberfläche erforderlich ist, gering.

Die Verwendung von Nebenprodukten als Stimulans für die IMP-Zersetzung wurde bei den derzeit verfügbaren CVD/ALD-Verfahren bisher noch nicht angemessen berücksichtigt. Die teilweise verschlossene Reaktionszone in der SRA-CVD-Abscheidevorrichtung erweist sich für die Hydrolysekinetik als vorteilhaft, da ein großer Anteil an Nebenprodukten zur Verfügung steht, um die Reaktion gleichzeitig in zwei entgegengesetzte Richtungen anzutreiben, und zwar in Richtung der Reaktanten- und der Produktseite. Zudem sind sie auch für die Vormodifikation der Substartoberfläche von großer Bedeutung.

Es ist bekannt, dass die mit konventionellen CVD-Verfahren bei Umgebungsdruck hergestellten Schichten von minderer Qualität sind. Unerwarteter Weise verfügen die mit dem neuen SRA-CVD-Verfahren hergestellten Schichten nachweislich über hervorragende Eigenschaften. Beispiele dafür sind eine hohe Dichte mit vernachlässigbaren Hohlräumen, das Fehlen struktureller Defekte, eine gleichmäßige Bedeckung verschiedener Oberflächentopographien, eine gute Haftung auf verschiedenen Substraten, eine atomare Oberflächenebenheit, eine hohe Beständigkeit gegen alkalische oder saure Lösungen, eine hohe Durchbruchsspannung, Abschirmfunktionen gegen Verunreinigungen, Beständigkeit gegen mechanische und thermische Belastungen usw.

Es kann festgestellt werden, dass die Eigenschaften der mit einem SRA-CVD-Verfahren erzeugten Schichten mit denen solcher Schichten übereinstimmen, die mit einem hohen Wärmebudget, niedrigem Druck und komplexen Werkzeugen abgeschieden wurden. Dabei gelingt die genaue Kontrolle der Konzentrationen der Reaktionsmoleküle im Inneren der Abscheidevorrichtung durch die Verwendung von Verdünnungsbehältern an den Verdampfern und die genaue Kontrolle der Temperaturen der Verdampfer mit widerstandsfähigen Silikonmänteln und thermischen Isolatoren. Den Gasmedien wird thermische Energie in Form von IR-Bestrahlung zugeführt, wobei die für eine Schichtabscheidung unerwünschten Bereiche der SRA-CVD-Abscheidevorrichtung gleichfalls erwärmt werden. Zur Einstellung der gewünschten Temperatur des Substrats wird seine Halterung mit einer differential-thermoelektrischen Heizvorrichtung versehen.

Die ausreichende Durchmischung der Reaktanten-Gase und die gleichmäßige Verteilung über einen weiten Bereich wird mit einer statischen Mischeinheit mit porösem Körper realisiert, in dem sich die Gasströme mehrfach aufspalten und dreidimensional in der Mischeinheit ausbreiten. Bei dem porösen Körper kann es sich um jedes lichtempfindliche Material handeln, das seine Oberflächenenergie durch die Einwirkung von UV-Strahlung ändert, z. B. TiOx, ZnO, usw.

Ein Entweichen der Gase während der Abscheidung wird dadurch unterbunden, dass das Volumen der Abscheidevorrichtung mit der Substrathalterung verschlossen wird, wobei jedoch ein winziger Spalt für den Druckausgleich verbleibt.

Alle derzeit verfügbaren Patente und Veröffentlichungen über die Abscheidung von Oxid- oder Oxinitrid-Schichten deuten darauf hin, dass die CVD bei Umgebungsdruck eine vielseitige Technik ist, die sowohl homogene als auch heterogene Reaktionen umfasst, unabhängig davon, welche Schichten gebildet werden sollen. Im Gegensatz dazu wird das erfindungsgemäße SRA-CVD-Verfahren zwangsweise durch eine rein heterogene Reaktion angetrieben. Wenn es um die Hydrolyse von Halogeniden unter Umgebungsbedingungen geht, hat keine Lösung zur Überwindung des Einflusses der Reaktion in der Gasphase eine durch UV- und / oder IR-Strahlung induzierte thermische Energie vorgeschlagen, die einem großvolumigen Medium, das die Substratoberfläche umgibt, zugeführt wird. Darüber hinaus wird bei dem SRA-CVD-Verfahren zum ersten Mal die UV-Photodissoziation allein oder in Kombination mit der CI-Katalyse eingesetzt, um die Hydrolmoleküle vor der Hydrolyse der Halogenide zu zersetzen.

Die Kombination der vier Komponenten der Abscheidevorrichtung - photoempfindliche Mischeinheit, konvergent-divergente Düse, Verteiler und Substrathalterung - ist im Stand der Technik der CVD und ALD, insbesondere zur Bildung dünner fester Schichten, noch nie dokumentiert worden. Im Gegensatz zu anderen Umgebungsdruck-CVD-Injektoren wird der SRA-CVD-Reaktor ohne Schutzgasschleier, bewegte Substrate (rotierend oder linear) oder kontinuierliche Nebenproduktableitung betrieben. Bei einer niedrigen Gesamtdurchflussrate (laminare Strömung) an den Einlässen der SRA-CVD-Abscheidevorrichtung werden Wirbel über der Substratoberfläche ohne kinetische Teile erzeugt, was eine große Herausforderung darstellt. Die erzielte homogene Durchmischung der Gasvorläufer sowie die gleichmäßige Verteilung über eine große Substratoberfläche führen zu einer gleichmäßigen Schichtdicke.

### Bezugszeichenliste

- 1 - 7 -: Ventile und Massendurchflussregeler für die Reaktanten und das Inertgas
- 8 -: Halogenid-Bubbler
- 9 -: Hydrolysemittel-Bubbler
- 10 -: Katalysator-Bubbler
- 11 -: Halogenid-Verdünnungsbehälter
- 12 -: Hydrolysemittel-Verdünnungsbehälter
- 13 -: Katalysator-Verdünnungsbehälter
- 14 -: Abscheidevorrichtung
- 15 -: Substrathalterung
- 16, 17 -: Auslassöffnungen
- 18 -: Rohrleitungsverteiler für Inertgas
- 19 -: Dichtkammer

## Patentansprüche

1. Verfahren zur Herstellung von Oxid- oder Oxinitridschichten auf einem Substrat durch Hydrolyse von Verbindungen auf Halogenbasis bei Umgebungsdruck in einer mit einer Substrathalterung (15) verschlossenen Abscheidevorrichtung (14), die in einer Dichtkammer (19) zusammen mit Halogenid-, Katalysator- und Hydrolysemittelzuführungssystemen (1 - 14) angeordnet ist, umfassend folgende Schritte:
• Spülung der Dichtkammer (19) mit einem Inertgas
• Einstellung und Stabilisierung der Durchflussmenge der Reaktantengase in den Zuführungssystemen (1 - 14)
• Einstellung eines definierten Temperaturprofils in der Dichtkammer (19) unter Beachtung des Gasdrucks der einzelnen Reaktanten
• Herstellung und Einstellung der Konzentrationen der Reaktantengase in den jeweiligen Zuführungssystemen (1 - 14)
• Einleitung der Reaktantengase in die Abscheidevorrichtung (14)
• Durchmischung der Reaktantengase und Transport des homogenen Gasgemisches zur und dessen Verteilung auf der Substratoberfläche, wobei bis zum Erreichen der Substratoberfläche eine Reaktion der Reaktantengase untereinander vermieden wird
• Hydrolyse der Verbindungen auf Halogenbasis und Adsorption auf der Substratoberfläche
• Schichtabscheidung auf der Substratoberfläche aufgrund der Oberflächenreaktion zwischen der Substratoberfläche und den adsorbierten Reaktantengasen,
wobei in der Abscheidevorrichtung (14) ein Temperaturprofil derart eingestellt wird, dass die Temperatur der zu beschichtenden Oberfläche des Substrates auf dem Substrathalter (15) geringer ist, als die Temperatur in der das Substrat auf der Substrathalterung (15) umgebenden Mischzone der Abscheidevorrichtung (14).

2. Verfahren nach Anspruch 1, **dadurch gekennzeichnet, dass** die Temperatur in der das Substrat auf der Substrathalterung (15) umgebenden Mischzone der Abscheidevorrichtung (14) zwischen 40 und 80 ºC beträgt und das Substrat auf dem Substrathalter (15) eine Temperatur im Bereich von -20 bis 60 °C, vorzugsweise Raumtemperatur, aufweist.

3. Verfahren nach Anspruch 1 oder 2, **dadurch gekennzeichnet, dass** die Hydrolyse der Verbindungen auf Halogenbasis während der Schichtabscheidung kontinuierlich durch ultraviolette (UV) Strahlung unterstützt wird.

4. Verfahren nach einem der Ansprüche 1 bis 3, **dadurch gekennzeichnet, dass** die Abscheidevorrichtung (14) mit Ausnahme der Substratoberfläche und das in ihrem Innern befindliche Gemisch der Reaktantengase mit Wärmeenergie, vorzugsweise mit infraroter (IR) Strahlung, beaufschlagt und auf eine Temperatur zwischen 40 und 80 °C erwärmt wird.

5. Verfahren nach einem der vorhergehenden Ansprüche, **dadurch gekennzeichnet, dass** vor und während des Abscheidungsprozesses eine definierte Menge HCl-Gas zugeführt wird.

6. Reaktorkonfiguration zur Herstellung von Oxid- oder Oxinitridschichten auf einem Substrat durch Hydrolyse von Verbindungen auf Halogenbasis bei Umgebungsdruck umfassend eine Dichtkammer (19), in welcher eine mit einer Substrathalterung (15) verschlossene Abscheidevorrichtung (14) und Halogenid-, Katalysator- und Hydrolysegaszuführungssysteme (1 - 14) angeordnet sind, **dadurch gekennzeichnet, dass** die Abscheidevorrichtung (14) eine unbewegliche Gasmischeinheit aufweist, die über eine konvergent-divergente Düse mit einem Expansionsverteiler verbunden ist, der mit der Substrathalterung (15) verschlossen ist.

7. Reaktorkonfiguration nach Anspruch 6, **dadurch gekennzeichnet, dass** die Gasmischeinheit ein Zylinder ist, in dem ein poröser Körper aus photoempfindlichem Material, insbesondere aus UV- und / oder IR-empfindlichen Material, angeordnet ist, wobei dessen erstes Ende mit einer kugelförmigen Einlasskappe und dessen zweites Ende mit einer konvergent-divergenten Düse gekoppelt ist, die mit einem pyramidenförmigen Expansionsverteiler verbunden ist.

8. Reaktorkonfiguration nach Anspruch 7, **dadurch gekennzeichnet, dass** am größten Umfang der kugelförmigen Einlasskappe Durchlassöffnungen mit einem in horizontaler Ebene um einen definierten geneigten Winkel angeordnet sind.

9. Reaktorkonfiguration nach einem der vorhergehenden Ansprüche, **dadurch gekennzeichnet, dass** die Abscheidevorrichtung (14) Einrichtungen zur Beaufschlagung der Gasmischeinheit, der konvergent-divergenten Düse, des Expansionsverteilers und der Substrathalterung mit UV-Strahlung und / oder Einrichtungen zur Beaufschlagung der Gasmischeinheit, der konvergent-divergenten Düse und des Expansionsverteilers mit IR-Strahlung umfasst.

10. Reaktorkonfiguration nach einem der vorhergehenden Ansprüche, **dadurch gekennzeichnet, dass** die Gasmischeinheit mit ihrer Einlasskappe, die konvergent-divergente Düse, der Expansionsverteiler und die Substrathalterung vertikal von oben nach unten angeordnet sind.

11. Reaktorkonfiguration nach einem der vorhergehenden Ansprüche, **dadurch gekennzeichnet, dass** die Substrathalterung (15) an ihrem Umfang eine schlitzförmige Auslassöffnung aufweist.

12. Reaktorkonfiguration nach einem der vorhergehenden Ansprüche, **dadurch gekennzeichnet, dass** die Abscheidevorrichtung (14) aus Teflon, teflonbeschichteten Kunststoffen, Oxiden oder anderen hydrophoben, korrosionsbeständigen Materialien und mit 3D-Druck-Verfahren hergestellt ist.
